# EUROPEAN PATENT APPLICATION

(11) **EP 4 213 067 A1**
(43) Date of publication of application: **19.07.2023**
(21) Application number: 21865983.7
(22) Date of filing: 08.09.2021
(51) Int. Cl.: G06K 9/00

(54) **ELECTRONIC DEVICE**

(30) Priority: 10.09.2020 CN 202010949366
(71) Applicant: Vivo Mobile Communication Co., Ltd., Dongguan, Guangdong 523863 (CN)
(72) Inventor: FU, Conghua, Dongguan, Guangdong 523863 (CN)
(74) Representative: Murgitroyd & Company
(86) International application number: PCT/CN2021/117076
(87) International publication number: WO 2022/052929

(57) **Abstract**

This application relates to the field of communication devices. Disclosed is an electronic device. The electronic device comprises a display module, a fingerprint identification module, and a first circuit board; the display module comprises a display screen, a second circuit board, and a first connecting portion; the display screen is electrically connected to the second circuit board, and the second circuit board is electrically connected to the first circuit board through the first connecting portion. The fingerprint identification module comprises a fingerprint sensor, a fingerprint driving unit, and a second connecting portion; the fingerprint sensor is provided on one side of the display screen away from a display surface of the display screen, the fingerprint sensor and the fingerprint driving unit are distributed at intervals, and the fingerprint sensor and the fingerprint driving unit are electrically connected to the first circuit board through the second connecting portion.

## Description

### CROSS-REFERENCE TO RELATED APPLICATIONS

The present invention claims priority to the Chinese Patent Application No. 202010949366.9, filed with the China National Intellectual Property Administration (CNIPA) on September 10, 2020, and entitled "ELECTRONIC DEVICE", which is incorporated herein by reference in its entirety.

### TECHNICAL FIELD

This application relates to the technical field of communication devices, and in particular to an electronic device.

### BACKGROUND

With the advances in technology and under the impact of users' favor in large display area, physical buttons on the front surfaces of many electronic devices are usually canceled and a fingerprint identification function is set on the back surfaces of the electronic devices. However, it is inconvenient for users to use when the fingerprint identification function is set on the back surfaces of the electronic devices, whereas an under-display fingerprint identification module can rightly take both large display area and user experience into account, so that more and more manufacturers begin to adopt this manner.

The under-display fingerprint identification module usually includes a fingerprint sensor and a fingerprint driving unit, which are connected with each other. The fingerprint driving unit is internally provided with components such as a main control chip. At present, in order to simplify a system structure and a circuit design, the fingerprint driving unit is usually attached to a circuit board of a display screen, the fingerprint driving unit is connected with the circuit board of the display screen through a connector, and the circuit board of the display screen can be connected to a first circuit board such as a main board or an auxiliary board of the electronic device through a connecting piece such as a flexible printed circuit board, so as to transmit a fingerprint signal and a display signal concurrently. However, during actual application of this design solution, the fingerprint driving unit occupies a larger area on the circuit board of the display screen, and both the fingerprint signal and the display signal communicate with the outside through the same flexible printed circuit board and connector, resulting in more design constraint conditions of the first circuit board and greater design difficulty.

### SUMMARY

This application discloses an electronic device to address the problem that in a current electronic device, a fingerprint driving unit occupies a larger area on a circuit board of a display screen, and a fingerprint signal and a display signal are transmitted concurrently, resulting in more design constraint conditions of a first circuit board and greater design difficulty.

To address the above problem, embodiments of this application are implemented as follows:

the embodiments of this application provide an electronic device, which includes a display module, a fingerprint identification module, and a first circuit board; the display module includes a display screen, a second circuit board, and a first connecting portion; the display screen is electrically connected to the second circuit board, and the second circuit board is electrically connected to the first circuit board through the first connecting portion;

the fingerprint identification module includes a fingerprint sensor, a fingerprint driving unit, and a second connecting portion; the fingerprint sensor is provided on one side of the display screen away from a display surface of the display screen, the fingerprint sensor and the fingerprint driving unit are distributed at intervals, and the fingerprint sensor and the fingerprint driving unit are electrically connected to the first circuit board through the second connecting portion.

In the electronic device disclosed by this application, the display module includes the display screen, the second circuit board, and the first connecting portion, and the display screen is electrically connected to the second circuit board; the fingerprint identification module includes the fingerprint sensor, the fingerprint driving unit, and the second connecting portion; the fingerprint sensor is provided on the side of the display screen away from the display surface, thereby empowering the electronic device with an under-display fingerprint identification function, improving the user experience of the electronic device, and also making the electronic device have a larger display area at the same time. The fingerprint sensor and the fingerprint driving unit are electrically connected to the first circuit board of the electronic device through the second connecting portion, so that the fingerprint driving unit may be prevented from occupying the area of the second circuit board in the display module, thereby reducing the overall size of the second circuit board. In addition, the second circuit board in the display module is electrically connected to the first circuit board through the first connecting portion, so that the fingerprint signal and the display signal in the electronic device are separated from each other, and are electrically connected to the first circuit board, respectively. Furthermore, both the fingerprint signal and the display signal are separately connected to the first circuit board during the design of the electronic device, so that constraint conditions required during the design of the first circuit board are relatively few and the design difficulty is relatively low. Additionally, in a case that the above technical solution is adopted, there is basically no stacking occurred between the fingerprint identification module and the display module, the two are separated to each other, so that the overall thickness of the display module and the fingerprint identification module may be smaller, facilitating the development of thin and light electronic devices.

### BRIEF DESCRIPTION OF THE DRAWINGS

The accompanying drawings described herein are provided for further understanding of this application, and constitute a part of this application. The exemplary embodiments and illustrations thereof of this application are intended to explain this application, but do not constitute inappropriate limitations to this application. In the accompanying drawings:
FIG. 1 is a schematic structural diagram of an electronic device disclosed by an embodiment of this application;
FIG. 2 is another schematic structural diagram of an electronic device disclosed by an embodiment of this application;
FIG. 3 is a schematic structural diagram of a middle frame of the electronic device shown in FIG. 2;
FIG. 4 is still another schematic structural diagram of an electronic device disclosed by an embodiment of this application;
FIG. 5 is a schematic structural diagram of a middle frame of the electronic device shown in FIG. 4;
FIG. 6 is yet another schematic structural diagram of an electronic device disclosed by an embodiment of this application;
FIG. 7 is a schematic structural diagram of a middle frame of the electronic device shown in FIG. 6;
FIG. 8 is yet another schematic structural diagram of an electronic device disclosed by an embodiment of this application;
FIG. 9 is a schematic structural diagram of a middle frame of the electronic device shown in FIG. 8;
FIG. 10 is a schematic diagram of an electronic device disclosed by an embodiment of this application in another direction; and
FIG. 11 is an assembly diagram of partial structure in an electronic device disclosed by an embodiment of this application.

### Reference Numerals:

110: display screen, 120: second circuit board, 130: first connecting portion, 140: first connector,

210: fingerprint sensor, 220: fingerprint driving unit, 230: second connecting portion, 231: first connecting segment, 232: second connecting segment, 233: third connecting segment, 240: second connector,

310: middle frame, 311: first opening, 312: second opening, 313: third opening, and 320: bonding layer.

### DETAILED DESCRIPTION

To make the objective, technical solutions, and advantages of this application clearer, the technical solutions of this application are clearly and completely described below with reference to the specific embodiments and corresponding accompanying drawings of this application. Apparently, the described embodiments are some rather than all of the embodiments of this application. All other embodiments obtained by those of ordinary skill in the art based on the embodiments of this application without creative efforts should fall within the protection scope of this application.

The technical solutions disclosed by various embodiments of this application will be further described in detail with reference to the accompanying drawings.

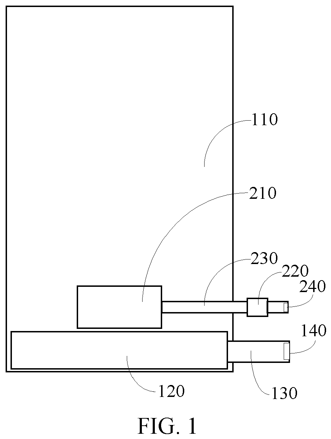

As shown in FIGS. 1 to 11, the embodiments of this application disclose an electronic device. The electronic device includes a display module, a fingerprint identification module, and a first circuit board. The first circuit board may be a main board of the electronic device. Certainly, in a case that an auxiliary board is provided within the electronic device, the first circuit board may also be the auxiliary board of the electronic device.

The display module includes a display screen 110, a second circuit board 120, and a first connecting portion 130. The display screen 110 is electrically connected to the second circuit board 120. The display screen 110 may be specifically connected to the second circuit board through a metal wire or in a welding manner, and structure parameters such as the size and shape of the display screen 110 may be flexible as required in practice. More specifically, the display screen 110 may be a touch control display screen. The second circuit board 120 may be provided with a display driving circuit. Certainly, the second circuit board 120 may also be provided with other components.

The first connecting portion 130 may be a metallic conductor or a flexible printed circuit board. In a case that the first connecting portion 130 is the flexible printed circuit board, the second circuit board 120 is electrically connected to the first circuit board through the first connecting portion 130; a fixed connection relation may be formed between the second circuit board 120 and the first connecting portion 130, and between the first connecting portion 130 and the first circuit board, respectively, in a manner such as tin soldering or conductive adhesive bonding, and an electric connection relation is formed at the same time, ensuring that information interaction may be performed between the display module and the first circuit board through the first connecting portion 130. Alternatively, a connector may be provided on each of two opposite ends of the first connecting portion 130, for example, a first connector 140 may be provided at one end of the first connecting portion 130 away from the second circuit board 120, so that the first connecting portion 130 may be electrically connected to the first circuit board with the aid of the first connector 140.

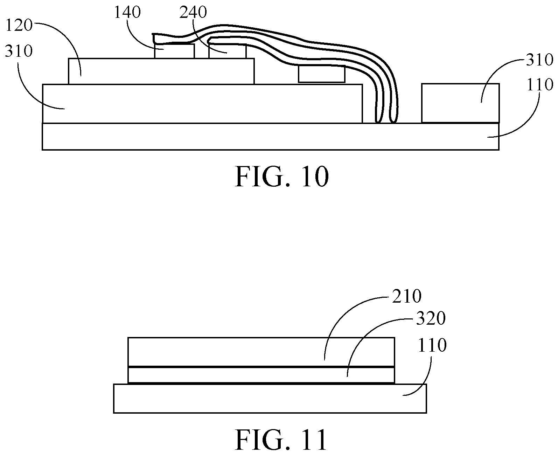

The fingerprint identification module includes a fingerprint sensor 210, a fingerprint driving unit 220, and a second connecting portion 230. The fingerprint sensor 210 is provided on one side of the display screen 110 away from a display surface of the display screen 110. Specifically, the fingerprint sensor 210 may be fixed on one side of the display screen 110 in a manner such as gripping, bonding or limited clamping. In order to improve the reliability of connection between the fingerprint sensor 210 and the display screen 110, as shown in FIG. 11, the fingerprint sensor 210 and the display screen 110 may be fixed together by bonding with the aid of a bonding layer 320. In this case, the fingerprint sensor 210 may also be attached to the surface of the display screen 110 as tight as possible to reduce a spacing between the fingerprint sensor 210 and the display screen 110 and improve the thin and light degree of the electronic device; and an air gap between the fingerprint sensor 210 and the display screen 110 may be basically removed to prevent dust from falling therebetween, improve the fingerprint recognition speed and accuracy, and further improve the user experience.

The fingerprint sensor 210 and the fingerprint driving unit 220 are distributed at intervals, and the size of an interval therebetween may be determined according to a space in the electronic device and actual parameters such as respective structures and sizes of the fingerprint sensor 210 and the fingerprint driving unit 220, which is not limited herein. The fingerprint driving unit 220 may specifically include functional modules such as a power management module, a logic control module, a data processing module, and a data transmission module. The above modules may be circuit units composed of components such as an integrated circuit, an inductor, a capacitor, and a resistor. Certainly, in a case that conditions such as an operating principle are different, the fingerprint driving unit 220 may also include other modules or other components.

The second connecting portion 230 may also be a metallic conductor or a flexible printed circuit board. In another embodiment of this application, the second connecting portion 230 is the flexible printed circuit board. In this case, the second connecting portion 230 may be used as a carrier of a plurality of components in the fingerprint driving unit 220; the components such as the integrated circuit, the inductor, the capacitor, and the resistor may be fixed on the second connecting portion 230 in a manner such as welding or conductive adhesive bonding, and each of the above components forms an electric connection relation with the second connecting portion 230. Considering that there are a large number of the components in the fingerprint driving unit 220 and in order to ensure that all components do not interfere with each other, optionally, the second connecting portion 230 may include a connecting sub-portion and a mounting sub-portion and the width of the mounting sub-portion is greater than the width of the connecting sub-portion. The fingerprint driving unit 220 is provided on the mounting sub-portion; the area of the mounting sub-portion per unit length is greater than the area of the connecting sub-portion per unit length, so that the mounting sub-portion has a larger mounting area, ensuring that there is a safety distance meeting the requirements among all components in the fingerprint driving unit 220 mounted on the mounting sub-portion. Moreover, the distribution of different parts in the fingerprint driving unit 220 may still be relatively intensive and the collaborative efficiency among the parts is improved.

Meanwhile, the fingerprint sensor 210 is also electrically connected to the second connecting portion 230, so that the aim of electrically connecting the fingerprint sensor 210 and the first circuit board is achieved through the second connecting portion 230. Optionally, two opposite ends of the second connecting portion 230 may be connected to the fingerprint sensor 210 and the first circuit board, respectively, in a welding manner. In another embodiment of this application, a second connector 240 is provided at one end of the second connecting portion 230 away from the fingerprint sensor 210, and the second connector 240 is electrically connected to the first circuit board.

In the electronic device disclosed by this application, the display module includes the display screen 110, the second circuit board 120, and the first connecting portion 130, and the display screen 110 is electrically connected to the second circuit board 120; the fingerprint identification module includes the fingerprint sensor 210, the fingerprint driving unit 220, and the second connecting portion 230; the fingerprint sensor 210 is provided on the side of the display screen 110 away from the display surface, thereby empowering the electronic device with an under-display fingerprint identification function, improving the user experience of the electronic device, and also making the electronic device have a larger display area at the same time. The fingerprint sensor 210 and the fingerprint driving unit 220 are electrically connected to the first circuit board of the electronic device through the second connecting portion 230, so that the fingerprint driving unit 220 may be prevented from occupying the area of the second circuit board 120 in the display module, thereby reducing the overall size of the second circuit board 120. In addition, the second circuit board 120 in the display module is electrically connected to the first circuit board through the first connecting portion 130, so that a fingerprint signal and a display signal in the electronic device are separated from each other, and are electrically connected to the first circuit board, respectively. Furthermore, both the fingerprint signal and the display signal are separately connected to the first circuit board during the design of the electronic device, so that constraint conditions required during the design of the first circuit board are relatively few and the design difficulty is relatively low. Additionally, in a case that the above technical solution is adopted, there is basically no stacking occurred between the fingerprint identification module and the display module, the two are separated to each other, so that the overall thickness of the display module and the fingerprint identification module may be smaller, facilitating the development of thin and light electronic devices.

Further, the electronic device further includes a middle frame 310, and the middle frame 310 may provide a certain supporting and protection effect for parts such as the display screen 110 and the first circuit board in the electronic device. The middle frame 310 may be made of a hard material such as metal or plastic, and the shape and specific size of the middle frame 310 may be determined according to an actual structure of a housing of the electronic device. The display screen 110 is usually provided on one side of the middle frame 310, whereas the first circuit board is usually provided on one side of the middle frame 310 away from the display screen 110, and therefore, it is necessary to extend the first connecting portion 130 and the second connecting portion 230 out from the edge of the middle frame 310, so as to be electrically connected to the first circuit board on the other side of the middle frame 310.

On the basis of the above content, optionally, an opening is formed in the middle frame 310, and both the first connecting portion 130 and the second connecting portion 230 which are located at one side of the middle frame 310 may extend out through the opening in the middle frame 310, and are electrically connected to the first circuit board located at the other side of the middle frame 310. The first connecting portion 130 is a strip-shaped structural member, and the opening may be formed toward the first connecting portion 130 to shorten the spacing between the opening and the second circuit board 120, thereby shortening the length of the first connecting portion 130. Meanwhile, one end of the second connecting portion 230 away from the fingerprint sensor 210 may also be arranged in parallel to the first connecting portion 130, so that when an end of the first connecting portion 130 and an end of the second connecting portion 230 penetrate into the opening of the middle frame 310, since at least a portion of each connecting portion is a strip-shaped structural member, it is only necessary to align the ends of the first connecting portion 130 and the second connecting portion 230 with the opening during a process of penetrating the first connecting portion 130 and the second connecting portion 230 through the opening, and there is basically no need to bend and deform the first connecting portion 130 and the second connecting portion 230 to a greater extent. Furthermore, this may ensure that both the first connecting portion 130 and the second connecting portion 230 have a longer service life, and the assembly difficulty between the first connecting portion 130 and the second connecting portion 230 and the opening of the middle frame 310 may also be reduced to a certain extent.

More specifically, only the portion of the second connecting portion 230 extending out through the opening to the other side of the middle frame 310 may be arranged in parallel to the first connecting portion 130. Alternatively, the whole body of the second connecting portion 230 may also be the strip-shaped structural member, and may be arranged in parallel to the first connecting portion 130. The opening may be formed in a manner such as drill machining. Alternatively, the middle frame 310 with the opening may be directly formed by changing the structure of a mold during a process of forming the middle frame 310; and additionally, the size, number, and setting position of the opening may be determined according to actual situations.

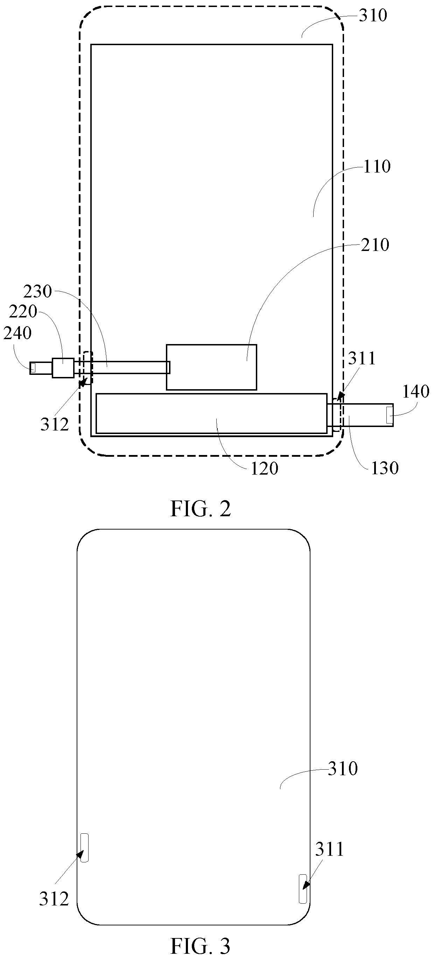

In a case that the electronic device is internally provided with the middle frame 310, optionally, as shown in FIGS. 2 to 5, a first opening 311 and a second opening 312, which are distributed at intervals from each other, are formed in the middle frame 310. During a process of assembling the electronic device, the first connecting portion 130 is capable of being electrically connected to the first circuit board through the first opening 311, and the second connecting portion 230 is capable of being electrically connected to the first circuit board through the second opening 312. In this case, both the first connecting portion 130 and the second connecting portion 230 may more easily extend from one side of the middle frame 310 to the other side of the middle frame 310, and are both electrically connected to the first circuit board.

Specifically, the width and height of the first opening 311 may be determined according to the width and height of the first connecting portion 130, and the size of the first opening 311 may not excessively exceed the size of the first connecting portion 130 in the corresponding direction, so as to ensure that the middle frame 310 has higher structural strength in a case that the first connecting portion 130 is capable of penetrating out from the first opening 311. Correspondingly, the size of the second opening 312 may also be determined according to the size of the second connecting portion 230 in the corresponding direction. It is to be noted that if the first connecting portion 130 and/or the second connecting portion 230 are/is provided with a component or other part and the like and need/needs to penetrate out through the first opening 311 and/or the second opening 312, the size of the first opening 311 and/or the second opening 312 may be correspondingly enlarged. In view of this, those skilled in the art may make flexible changes according to actual situations.

Also, in a case that the first opening 311 and the second opening 312 are distributed at intervals from each other, the local strength of a region where the first opening 311 and the second opening 312 are located on the middle frame may be reinforced to a certain extent through the connection structure between the first opening and the second opening, ensuring that the structural strength of any position on the middle frame 310 is relatively great.

More specifically, as shown in FIGS. 2 and 3, the first opening 311 and the second opening 312 may be formed in two opposite sides of the middle frame 310, respectively. In this case, the extending directions of the first connecting portion 130 and the second connecting portion 230 are opposite. The first connecting portion 130 extends toward one side of the display screen 110 and the second connecting portion 230 extends toward the other side of the display screen 110. In a case that this technical solution is adopted, the spacing between the first opening 311 and the second opening 312 may be relatively large; and since they are located at different sides of the middle frame 310, respectively, the local structural strength of the middle frame 310 may be less affected due to the first opening 311 and the second opening 312 formed in the middle frame 310, so as to further ensure better uniformity of the overall structural strength of the middle frame 310.

In addition, a filling structure may be provided in a gap between the first opening 311 and the first connecting portion 130, and/or a filling structure may be provided in a gap between the second opening 312 and the second connecting portion 230, thereby further reinforcing the structural strength of the middle frame 310.

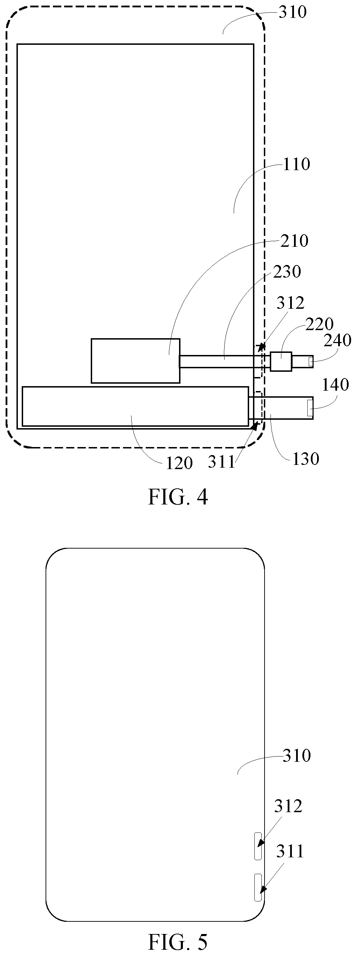

In another embodiment of this application, as shown in FIGS. 4 and 5, the first opening 311 and the second opening 312 are located at the same side of the middle frame 310. In this case, the extending directions of the first connecting portion 130 and the second connecting portion 230 are the same, and they both extend toward the same side of the display screen 110, and penetrate through the first opening 311 and the second opening 312, respectively, so as to be electrically connected to the first circuit board. It is to be noted that the first opening 311 and the second opening 312 are not necessarily formed in the side edge of the middle frame 310, and may also be formed in other positions adjacent to the edge in the middle frame 310.

In a case that the above technical solution is adopted, since the first connecting portion 130 and the second connecting portion 230 extend in the same direction, when one group of the first connecting portion 130 and the first opening 311, and the second connecting portion 230 and the second opening 312 is aligned, the other group is basically in an aligned state; meanwhile, in a case that the first connecting portion 130 and the second connecting portion 230 extend in the same direction, the first connecting portion 130 and the second connecting portion 230 only occupy a space at one side in the second circuit board 120, so that the overall size of a middle structural member composed of the second circuit board 120, the fingerprint sensor 210, the first connecting portion 130 and the second connecting portion 230 is relatively small, facilitating storage and transportation.

In still another embodiment of this application, a third opening 313 may also be formed in the middle frame 310, and both the first connecting portion 130 and the second connecting portion 230 are electrically connected to the first circuit board through the third opening 313, that is, the first connecting portion 130 and the second connecting portion 230 penetrate through the same opening to the other side of the middle frame 310. In this case, the assembly difficulty of the electronic device may be further reduced, and the difficulty and accuracy requirements of forming one opening are generally less than the difficulty and accuracy requirements of forming two openings during the machining process.

Further, the first connecting portion 130 and the second connecting portion 230 may be distributed at intervals in a direction perpendicular to the display screen 110 and the extending direction of the first connecting portion 130. The third opening 313 may be formed in one side of the middle frame 310 in a width direction of the display screen 110, and may also be formed in one side of the middle frame 310 in a length direction of the display screen 110.

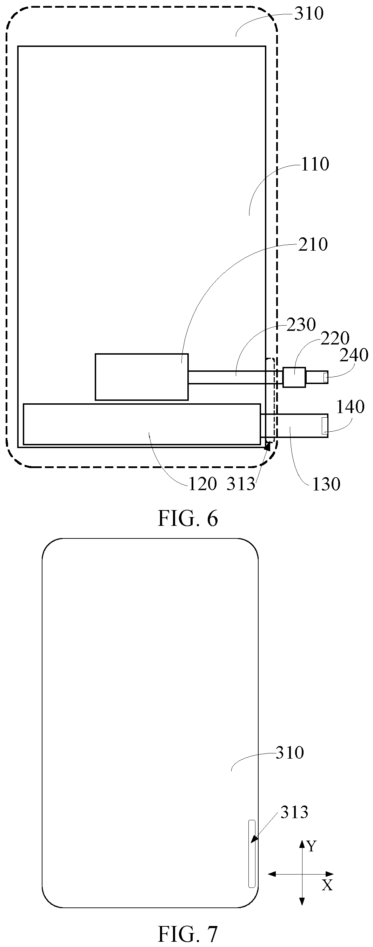

In more detail, as shown in FIGS. 6 and 7, in a case that the third opening 313 is located at the side in the length direction of the display screen 110, the extending direction of the first connecting portion 130 is the width direction of the display screen 110 and the direction perpendicular to the display screen 110 and the extending direction of the first connecting portion 130 is the length direction of the display screen 110, that is, the first connecting portion 130 and the second connecting portion 230 may be distributed at intervals along the length direction of the display screen 110, or projections of the first connecting portion 130 and the second connecting portion 230 in the direction perpendicular to the display screen 110 are not overlapped. A thickness direction of the display screen 110 may be the direction perpendicular to the paper surface in FIG. 7, the extending direction of the first connecting portion 130, that is, the width direction of the display screen 110, may be the direction X in FIG. 7, and the length direction of the display screen 110 may be the direction Y in FIG. 7.

In this case, the size of the third opening 313 in the length direction of the display screen 110 is relatively large, which may reduce the penetrating difficulty of the first connecting portion 130 and the second connecting portion 230 to a certain extent; moreover, there is no need to particularly adjust the positions of the first connecting portion 130 and the second connecting portion 230 and it is only necessary to determine the size of the third opening 313 according to the spacing between the first connecting portion 130 and the second connecting portion 230 in the length direction of the display screen 110 and then lead out the first connecting portion 130 and the second connecting portion 230 from the same side of the fingerprint sensor 210 and the second circuit board 120, which may reduce the overall machining difficulty of the electronic device to a certain extent.

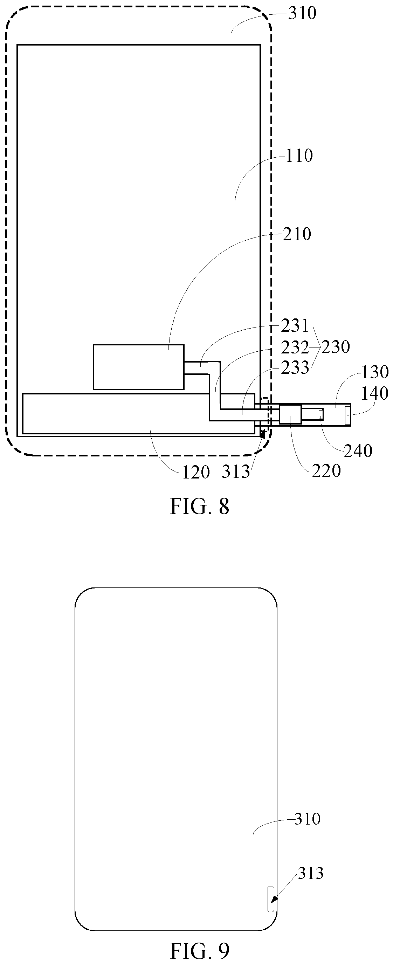

As above, the third opening 313 may be formed in the side in the length direction of the display screen 110, and the first connecting portion 130 extends along the width direction of the display screen 110. In a case that both the first connecting portion 130 and the second connecting portion 230 penetrate out through the third opening 313, optionally, as shown in FIGS. 8 and 9, at least a portion of one end of the second connecting portion 230 away from the fingerprint sensor 210 is stacked with the first connecting portion 130 along the thickness direction of the display screen 110, which may make the size of the third opening 313 in the length direction of the display screen 110 relatively small. That is, in a case that the above technical solution is adopted, the overall size of the third opening 313 is relatively small, thereby minimizing the extent of structural strength reduction of the middle frame 310 due to the setting of the third opening 313.

Certainly, in a case that the above technical solution is adopted, it is necessary to further enlarge the size of the third opening 313 in the thickness direction of the display screen 110, so as to ensure that the stacked first connecting portion 130 and second connecting portion 230 can penetrate out from the third opening 313. However, since the acting force on the middle frame 310 in the thickness direction of the display screen 110 is relatively small during the use of the electronic device, the influence on the structural strength of the middle frame 310 is also relatively small even if the size of the third opening 313 in the thickness direction of the display screen 110 becomes large. Additionally, since the thicknesses of the first connecting portion 130 and the second connecting portion 230 are relatively small, the thickness of a whole body composed of the display module and the fingerprint identification module is basically not influenced even if at least a portion of each connecting portion is arranged in the above stacking manner. Additionally, as above, connectors may be provided at the ends of the first connecting portion 130 and the second connecting portion 230. Generally, in the thickness direction of the display screen 110, the sizes of the connectors are greater than the sizes of the first connecting portion 130 and the second connecting portion 230, and therefore, the size of the third opening 313 in the thickness direction of the display screen 110 may be correspondingly designed according to the sizes of the connectors during the actual use, so as to ensure that the connectors can penetrate out from one side of the third opening 313 to the other side of the third opening 313. It is to be noted that two opposite sides of the third opening 313 may be regarded as an inner side and an outer side of the middle frame 310, and may also be regarded as a front side and a back side of the middle frame 310.

More specifically, the first connector 140 is provided at one end of the first connecting portion 130 away from the second circuit board 120, and the second circuit board 120 is electrically connected to the first circuit board through the first connector 140; correspondingly, the second connector 240 is provided at one end of the second connecting portion 230 away from the fingerprint sensor 210, and the fingerprint sensor 210 is electrically connected to the first circuit board through the second connector 240, so as to further reduce the assembly and repairing difficulty of the parts in the electronic device.

On the basis of the above embodiments, further, as shown in FIG. 8, the first connector 140 and the second connector 240 may be distributed along the extending direction of the first connecting portion 130. In this case, the first connector 140 and the second connector 240 may be distributed in a staggered manner, and furthermore, during a process of assembling the electronic device, one of the first connector 140 and the second connector 240 may firstly penetrate out through the third opening 313, and then the other one may penetrate out through the third opening 313, so that the size of the third opening 313 in the thickness direction of the display screen 110 may be smaller than the sum of the sizes of the first connector 140 and the second connector 240 during a process of designing the third opening 313. This may further reduce the size of the third opening 313 in the thickness direction of the display screen 110, thereby improving the overall structural strength of the middle frame 310.

As above, in a case that the first connector 140 and the second connector 240 are staggered from each other, the extending lengths of the first connecting portion 130 and the second connecting portion 230 from the middle frame 310 may also be different. In order to facilitate the simultaneous extension of the first connecting portion 130 and the second connecting portion 230 from the third opening 313, a double-sided tape with smaller viscosity may be provided between the first connecting portion 130 and the second connecting portion 230, so that the first connecting portion 130 and the second connecting portion 230 temporarily form a whole body; after the whole body penetrates out through the third opening 313, the double-sided tape may be removed and the first connecting portion 130 and the second connecting portion 230 are separated and electrically connected to different positions of the first circuit board, respectively.

As above, both the second circuit board 120 and the fingerprint sensor 210 are provided on the side of the display screen 110 away from the display surface. Optionally, the second circuit board 120 and the fingerprint sensor 210 may be provided on different regions of the surface of the display screen 110, respectively. In this case, the thickness of a whole body composed of the display screen 110, the second circuit board 120, and the fingerprint sensor 210 may be reduced.

Further, in a case that both the first connecting portion 130 and the second connecting portion 230 penetrate through the third opening 313, the first connecting portion 130 may be the strip-shaped structural member and the second connecting portion 230 may be of a bent structure. As shown in FIG. 8, the second connecting portion 230 includes a first connecting segment 231, a second connecting segment 232, and a third connecting segment 233. The first connecting segment 231 is connected to the fingerprint sensor 210, and both the first connecting segment 231 and the third connecting segment 233 extend along the extending direction of the first connecting portion 130, that is, both the first connecting segment 231 and the third connecting segment 233 are parallel to the first connecting portion 130. The third connecting segment 233 is connected to the first connecting segment 231 through the second connecting segment 232. Specifically, the second connecting segment 232 may be perpendicular to the first connecting segment 231, and may also be arranged obliquely relative to the first connecting segment 231; and the second connector 240 is provided at one end of the third connecting segment 233 away from the second connecting segment 232.

In a case that the above technical solution is adopted, it may be ensured that at least a portion of the end of the second connecting portion 230 away from the fingerprint sensor 210 is stacked with the first connecting portion 130 in the thickness direction of the display screen 110, and the structure of the whole second connecting portion 230 may also be more regular, facilitating the improvement of neatness of wiring in the electronic device.

In a case that the electronic device is provided with the middle frame 310, both the first connecting portion 130 and the second connecting portion 230 may penetrate out through the opening. As above, the fingerprint driving unit 220 usually includes a plurality of components, and the plurality of components form a whole body with the aid of a structure such as the second connecting portion 230, which makes the fingerprint driving unit 220 occupy the space of one side of the second connecting portion 230 away from the display screen 110. Further, as shown in FIGS. 1, 2, 4, 6 and 8, a portion of the second connecting portion 230 is connected to the fingerprint sensor 210 and is located at one side of the opening, and the fingerprint driving unit 220 is fixed on the other portion of the second connecting portion 230 and the other portion of the second connecting portion 230 is located at the other side of the opening. In this case, the fingerprint driving unit 220 and the fingerprint sensor 210 may be provided on two opposite sides of the middle frame 310, respectively, so that the spacing between the middle frame 310 and the display screen 110 may be reduced, making the parts in the electronic device more compact and improving the space utilization rate in the electronic device.

In order to further improve the thin and light degree of the electronic device and improve the space utilization rate in the electronic device, optionally, as shown in FIG. 10, the display screen 110 and the second circuit board 120 are provided on two opposite sides of the middle frame 310, respectively. In this case, the second circuit board 120 does not occupy a space between the display screen 110 and the middle frame 310, so that the attachment height between the display screen 110 and the middle frame 310 may be reduced. Further, the display screen 110 may be attached to the middle frame 310, so that the spacing between the display screen 110 and the middle frame 310 is basically 0, thereby further reducing the thickness of the electronic device.

The electronic device disclosed by the embodiments of this application may be a smart phone, a tablet computer, an e-book reader, or a wearable device. Certainly, the electronic device may also be other device, which is not limited by the embodiments of this application.

The above embodiments of this application focus on the differences among various embodiments, and different optimization features among the various embodiments may be combined to form a preferred embodiment in case of no conflict. For the brevity of writing, details are not described herein.

The above merely describes the embodiments of this application, and is not intended to limit this application. Various changes and modifications can be made to this application by those skilled in the art. Any modifications, equivalent replacements, improvements and the like made within the spirit and scope of this application should all fall within the scope of claims of this application.

## Claims

1. An electronic device, comprising a display module, a fingerprint identification module, and a first circuit board, wherein the display module comprises a display screen (110), a second circuit board (120), and a first connecting portion (130); the display screen (110) is electrically connected to the second circuit board (120), and the second circuit board (120) is electrically connected to the first circuit board through the first connecting portion (130); and
the fingerprint identification module comprises a fingerprint sensor (210), a fingerprint driving unit (220), and a second connecting portion (230); the fingerprint sensor (210) is provided on one side of the display screen (110) away from a display surface of the display screen (110), the fingerprint sensor (210) and the fingerprint driving unit (220) are distributed at intervals, and the fingerprint sensor (210) and the fingerprint driving unit (220) are electrically connected to the first circuit board through the second connecting portion (230).

2. The electronic device according to claim 1, wherein the electronic device comprises a middle frame (310); an opening is formed in the middle frame (310); the first connecting portion (130) is a strip-shaped structural member; and one end of the second connecting portion (230) away from the fingerprint sensor (210) is arranged in parallel to the first connecting portion (130).

3. The electronic device according to claim 1, wherein the electronic device further comprises a middle frame (310); a first opening (311) and a second opening (312), which are distributed at intervals from each other, are formed in the middle frame (310); the first connecting portion (130) is electrically connected to the first circuit board through the first opening (311); and the second connecting portion (230) is electrically connected to the first circuit board through the second opening (312).

4. The electronic device according to claim 3, wherein the first opening (311) and the second opening (312) are located at a same side of the middle frame (310).

5. The electronic device according to claim 1, wherein the electronic device further comprises a middle frame (310); a third opening (313) is formed in the middle frame (310); and both the first connecting portion (130) and the second connecting portion (230) are electrically connected to the first circuit board through the third opening (313).

6. The electronic device according to claim 5, wherein the first connecting portion (130) and the second connecting portion (230) are distributed at intervals in a direction perpendicular to the display screen (110) and an extending direction of the first connecting portion (130).

7. The electronic device according to claim 5, wherein at least a portion of one end of the second connecting portion (230) away from the fingerprint sensor (210) is stacked with the first connecting portion (130) along a thickness direction of the display screen (110).

8. The electronic device according to claim 7, wherein a first connector (140) is provided at one end of the first connecting portion (130) away from the second circuit board (120), a second connector (240) is provided at the end of the second connecting portion (230) away from the fingerprint sensor (210), and the first connector (140) and the second connector (240) are distributed along an axial direction of the third opening (313).

9. The electronic device according to claim 8, wherein the second connecting portion (230) comprises a first connecting segment (231), a second connecting segment (232) and a third connecting segment (233); the first connecting segment (231) is connected to the fingerprint sensor (210); both the first connecting segment (231) and the third connecting segment (233) extend along an extending direction of the first connecting portion (130); the third connecting segment (233) is connected to the first connecting segment (231) through the second connecting segment (232); and the second connector (240) is provided at one end of the third connecting segment (233) away from the second connecting segment (232).

10. The electronic device according to claim 1, wherein the electronic device comprises a middle frame (310); an opening is formed in the middle frame (310); a portion of the second connecting portion (230) is connected to the fingerprint sensor (210) and is located at one side of the opening; and the fingerprint driving unit (220) is fixed on another portion of the second connecting portion (230) and the another portion of the second connecting portion (230) is located at another side of the opening.
